# EUROPÄISCHE PATENTSCHRIFT

(11) **EP 2 091 799 B1**
(45) Veröffentlichungstag und Bekanntmachung des Hinweises auf die Patenterteilung: **12.05.2010**
(21) Anmeldenummer: 08700283.8
(22) Anmeldetag: 17.01.2008
(51) Int. Cl.: B61L 7/06, B61L 5/06

(54) **VORRICHTUNG ZUR KONTAKTLOSEN ERMITTLUNG DES ENERGIEBEDARFS EINES WEICHENSTELLANTRIEBS**
DEVICE FOR THE CONTACTLESS DETERMINATION OF THE ENERGY REQUIREMENTS OF A POINT ACTUATING DRIVE
DISPOSITIF DESTINÉ À LA DÉTERMINATION SANS CONTACT DE LA CONSOMMATION EN ÉNERGIE D'UN MÉCANISME DE MANOEUVRE D'AIGUILLAGE

(30) Priorität: 23.01.2007 AT 1182007
(43) Veröffentlichungstag der Anmeldung: 26.08.2009
(73) Patentinhaber: VAE EISENBAHNSYSTEME GMBH, 8740 Zeltweg (AT); VAE GmbH, 1010 Wien (AT)
(72) Erfinder: TAFEIT, Dietmar, A-8740 Zeltweg (AT); JERNEJ, Günther, A-8010 Graz (AT)
(74) Vertreter: Haffner und Keschmann Patentanwälte OG
(86) Internationale Anmeldenummer: PCT/AT2008/000016
(87) Internationale Veröffentlichungsnummer: WO 2008/089502

(56) Entgegenhaltungen:
- EP-A- 0 749 883
- EP-A- 1 541 441
- EP-A- 1 593 574
- WO-A-01/85523
- DE-A1- 3 612 652
- GARDAVSKY K ET AL: "NEUES INNOVATIVES WEICHENSTELLSYSTEM VON SIEMENS" SIGNAL + DRAHT, TELZLAFF VERLAG GMBH. DARMSTADT, DE, Bd. 91, Nr. 3, 1. März 1999 (1999-03-01), Seiten 31-34, XP009037363 ISSN: 0037-4997

## Beschreibung

Die Erfindung bezieht sich auf eine Vorrichtung zur kontaktlosen Ermittlung des Energiebedarfs eines Weichenstellantriebs mit an eine Drehstromquelle über Leiter angeschlossenen Asynchronmotoren.

Zum rechtzeitigen Erkennen von Störungen im Betriebsverhalten eines Stellantriebs von Eisenbahnweichen ist eine Reihe von Einrichtungen und Diagnosemodulen bekannt geworden. Zum Umstellen von Weichen wird bei gebräuchlichen Weichenantriebssystemen ein mechanisches Weichengestänge, welches von einem Weichenantrieb bewegt wird, eingesetzt. Verschmutzung und/oder Korrosion sowie andere Umwelteinflüsse können zu einer Schwergängigkeit der Weichenzunge führen, die zu Störungen beim Umstellen führen kann.

Am häufigsten zum Einsatz gelangen für derartige Weichenantriebe Asynchronmotoren, welche über eine Vierdrahtschnittstelle von einem Stellwerk gesteuert werden. Über die vier Leiter werden Wechselspannungen geführt, wobei in der Regel zwei Leiter mit phasenverschobenen Wechselspannungen beaufschlagt sind. Asynchronmotoren zeichnen sich nun dadurch aus, dass sie im Leerlauf bzw. im unbelasteten Zustand einen sehr hohen Blindstromanteil aufweisen. Der Blindstromanteil verringert sich bei Belastung des Weichenantriebs, wobei der entsprechende phasenwinkelabhängige Faktor cos φ von etwa 0,2 auf etwa 0,5 bis 0,6 ansteigt, wenn der Weichenantrieb bei der Umstellung seine maximale Stellkraft erreicht.

Prinzipiell wird mit einer Reihe bekannter Diagnoseeinrichtungen die Verlustleistung berücksichtigt. Insbesondere ist es gebräuchlich, die Verlustleistung aus einem aus den Plänen der Anlage, d.h. des Weichenantriebs, berechneten Leitungswiderstands zu berechnen. Eine Reihe weiterer Lösungen sieht vor, den Leitungswiderstand mittels Gleichstroms zu messen, was zumindest den Blindwiderstand und damit den Blindanteil der Leistung des Motors des Weichenantriebs eliminiert. Derartige Lösungen erfordern jedoch einen zusätzlichen Schaltungsaufwand bei der Steuerung des Weichenantriebs und damit zusätzliche Kosten. Aus der DE 3715478 ist es in diesem Zusammenhang bekannt, an allen drei Phasen R, S und T eines Weichentransformators und dem Mittelpunktsleiter der Drehstromantriebe Stromüberwacher anzuordnen. Der DE 19749842 ist ein Diagnosemodul zu entnehmen, das während der Überprüfung nicht mit der zentralen Auswerteeinheit verbunden sein muss und eine relativ kleine Versorgungsspannung benötigt, die über mindestens einen der Anschlüsse an der Baueinheit oder über ein externes Signal aktivierbar ist. Es werden Spannungssignale und Stromsignale ausgewertet, wobei insgesamt in die Schaltungsanordnung wiederum eingegriffen wird. In der EP 1541441 wird die aufgenommene Leistung des Weichenantriebs beim Umstellvorgang über eine Leistungsmessung bestimmt. In diesem Fall wird der Leitungswiderstand und/oder die Verlustleistung ermittelt und die Gesamtleistungsaufnahme des Drehstrommotors gemessen und mit einem von der Verlustleistung abhängigen Leistungskorrekturwert korrigiert. Zu diesem Zweck müssen Spannung, Strom und Phasenwinkel bei noch stillstehendem Motor bestimmt werden, um den Direktwiderstand des Stromkreises zu ermitteln. Ebenso wie bei der aus der WO 01/85523 bekannten Weichendiagnosevorrichtung ist eine Messung nur möglich, wenn in die Verdrahtung kontaktbehaftet eingegriffen wird. Bei der WO 01/85523 wird außerhalb der eigentlichen Umlaufphase des Drehstromantriebs die Weichendiagnoseeinrichtung eingangsseitig von den Speiseleitungen des Antriebs getrennt. Auch die EP 734932 zeigt und beschreibt eine kontaktbehaftete Einrichtung, bei welcher in die zum Drehstromantrieb führenden Leitungen elektrische Testsignale über Einzelgeneratoren aufgegeben werden, sodass durch die vom Drehstromantrieb beeinflussten Signale Messgrößen ermittelt werden können. Eine kontaktlose Einrichtung ist der EP 1535819 zu entnehmen, bei welcher zum Messen des elektrischen Stroms vorgeschlagen wird, im Bereich eines Sensors eine Prüfspule anzuordnen, durch die ein im Stromwert und in der Stromrichtung vorgegebener Stromimpuls geschickt wird. Eine Messung des Blindstromanteils wird bei einer derartigen Vorrichtung nicht vorgenommen, sondern lediglich elektrischer Strom in Leitungen einer sicherungstechnischen Einrichtung erkannt.

Die Erfindung zielt nun darauf ab, eine Vorrichtung der eingangs genannten Art zu schaffen, bei welcher für die Beurteilung des Weichenzustands der tatsächlich aufgenommene Energiebedarf eines Drehstrommotors beim Umstellvorgang eines Weichenantriebs besser erfasst werden kann und insbesondere größere und von Fehlerquellen und insbesondere von Blindstromkomponenten befreite Signale ausgewertet werden können. Die erfindungsgemäße Vorrichtung soll mit geringem Energieaufwand ohne Eingriff in die sicherungstechnische Schaltung kontaktlos und rückwirkungsfrei betrieben werden können. Zur Lösung dieser Aufgabe besteht die erfindungsgemäße Vorrichtung im wesentlichen darin, dass wenigstens eine Drossel, insbesondere Drosselspule, parallel zu einem Phasenleiter geschaltet ist und der an die Drossel anschließende Leiter entgegengesetzt zu dem mit dem Motor verbundenen Phasenleiter an oder durch einen Sensor geführt ist, wobei durch die in der Drossel erzeugte Blindstromkomponente die in der über die Motorwicklung geführten Leitung zusätzlich zur Wirkstromkomponente enthaltene Blindstromkomponente zumindest teilweise kompensiert wird. Es wird somit so vorgegangen, dass parallel zu einem Phasenleiter des Asynchronmotors eine Drossel zur Ausbildung einer Blindstromkomponente geschaltet ist und dass der Phasenleiter und der von der Drossel zum Rückleiter geführte Leiter zueinander entgegengesetzt geführt und von einem Sensor abgetastet werden, wobei durch die in der Drossel erzeugte Blindstromkomponente die in der über die Motorwicklung geführten Leitung zusätzlich zur Wirkstromkomponente enthaltene Blindstromkomponente zumindest teilweise kompensiert wird. Ausgehend von der eingangs vorausgesetzten Stromversorgung, nämlich Weichentransformatoren, welche Dreiphasendrehstromnetze zur Verfügung stellen und ausgehend von der Tatsache, dass derartige betreiberseitig vorgesehene Weichentransformatoren mit der richtigen Phasenlage in die jeweilige Weichenstellung geschaltet werden, wird durch die Erfindung sichergestellt, dass eine vordefinierte Blindstromkomponente durch die Drossel erzeugt wird und dadurch, dass der diese vordefinierte Blindstromkomponente führende Leiter den jeweiligen Phasenleiter entgegengesetzt von einem Sensor abgetastet wird, wird die Möglichkeit geschaffen, ein entsprechend kompensiertes und um Blindstromanteil bereinigtes Signal einer Auswertung zu unterziehen. Es wird damit prinzipiell die Möglichkeit geschaffen, über den Sensor, wie beispielsweise einen entsprechenden Stromwandler, und eine Auswerteelektronik während der Weichenumstellung ein Messergebnis zu erzielen, bei welchem der über die Drossel induktiv erzeugte entgegengesetzte Blindstrom vom in der Phase fließenden Strom entsprechend subtrahiert wird eine fast vollständige Blindstromkompensation erfolgen kann, sodass ein Ausgangssignal erzielt werden kann, bei dem der Blindstromanteil aufgehoben ist und damit ein Anstieg des Energieaufwands für den Umstellvorgang wesentlich deutlicher erfassbar wird. Es wird nämlich der in der Anschlussleitung gemessene Scheinstrom des Drehstromantriebs durch den gleichphasigen Blindstrom kompensiert, was durch entsprechend einfache Mittel und konstruktive Lösungen erzielt werden kann. In besonders geeigneter Weise wird für diese Zwecke die T-Phase herangezogen, die von der Weichenstellgruppe immer in der gleichen Phasenlage zum Weichenantrieb ausgegeben wird. Um nun zusätzlich erkennen zu können, in welche Stellrichtung der Weichenantrieb beaufschlagt wird, ist die erfindungsgemäße Vorrichtung mit Vorteil so weitergebildet, dass wenigstens ein weiterer Sensor an oder um einen Phasenleiter, insbesondere Außenleiterphase und den zu dieser Phase entgegengesetzt verlaufenden Rückleiter angeordnet ist, wobei der Phasenleiter und der Rückleiter unter Verwendung des weiteren Sensors zur Ermittlung der Drehrichtung ausgewertet werden. In diesem Fall wird über einen weiteren Stromwandler der über die R-Phase bzw. erste Phase fließende Strom gemeinsam mit dem Retourleiter erfasst und wiederum mittels der angeschlossenen Auswerteelektronik bei einem Weichenumlauf die Weichenstellung ermittelt und dem gemessenen Energieaufwand der Weichenumstellung zugeordnet. Zu diesem Zweck wird die Tatsache ausgenutzt, dass bei der Umstellung in eine erste Richtung während der ersten 200 ms kein nennenswerter Stromanstieg erkennbar ist. Während dieses gleichen Zeitfensters, in welchem sich Ströme durch den Stromwandler vom Außenleiter und dem Retourleiter im Ausgangssignal vom Stromwandler aufheben, kann in die andere Umstellrichtung ein Ausgangssignal erzielt werden, welches einen deutlichen Stromanstieg aufweist, wodurch die Umstellrichtung von der Auswerteelektronik bestimmt werden kann.

Insgesamt ist es, wie eingangs erwähnt, für die Ermittlung des aufgenommenen Energiebedarfs des Weichedrehstromantriebs von besonderem Vorteil, die T-Phase, die von der Weichestellgruppe immer in gleicher Phasenlage zum Weichenantrieb ausgegeben wird, heranzuziehen. Prinzipiell ist es zur Kompensation erforderlich, die jeweiligen Ströme in entgegengesetzter Richtung an oder durch die Sensoren hindurchzuführen, wobei die Vorrichtung mit Vorteil derart ausgebildet wird, dass die Sensoren von den jeweiligen Phasen bzw. dem Rückleiter in axialer Richtung durchsetzt werden, wobei mit Vorteil als Sensoren Stromwandler bzw. Stromzangen eingesetzt werden.

Die erfindungsgemäße Vorrichtung zur kontaktlosen Ermittelung des Energiebedarfs eines Weichenstellantriebs mit an eine Drehstromquelle über Leiter angeschlossene Asynchronmotoren ist so ausgebildet, dass wenigstens eine Drosselspule parallel zu einem Phasenleiter geschaltet ist und der an die Drosselspule anschließende Leiter entgegengesetzt zu dem mit dem Motor verbundenen Phasenleiter an oder durch einen Sensor geführt ist, wobei durch die in der Drossel erzeugte Blindstromkomponente die in der über die Motorwicklung geführten Leitung zusätzlich zur Wirkstromkomponente enthaltene Blindstromkomponente zumindest teilweise kompensiert wird. Auf diese Weise wird die gewünschte Kompensation bzw. Aufhebung des Blindstromanteils, welcher durch die Drosselspule erzeugt wird, gewährleistet, wobei hier eine entsprechende Dimensionierung zur Verbesserung der Kompensation gewählt werden kann. Drehstromweichenantriebe weisen beispielsweise maximale Stellströme von etwa 4 A auf. In diesem Fällen kann es durchaus ausreichen, eine entsprechend kleiner dimensionierte Drossel, welche für beispielsweise 0,6 bis 0,7 A ausgelegt ist, einzusetzen, wobei in diesem Fall die entsprechende Signalkompensation dadurch in einfacher Weise gelingt, dass die Leitung im Stromwandler mehrfach hindurchgeführt wird, wobei die Anzahl der Windungen, welche in diesem Zusammenhang eingesetzt werden, von der Nennleistungsaufnahme des Drehstrommotors abhängig gewählt werden kann. Die erfindungsgemäße Vorrichtung ist daher mit Vorteil so dimensioniert bzw. ausgelegt, dass der an die Drossel anschließende Leiter einfach oder in Form von Leiterwindungen mehrfach entgegengesetzt dem Phasenleiter an oder durch den Sensor geführt ist, wobei bei Einsatz der zuvor genannten Drossel, welche auf 0,6 bis 0,7 A ausgelegt sein kann, beispielsweise eine fast vollständige Kompensation des Blindstromanteils für einen 0,5 KW Drehstrommotor mit nur einer Windung und bei Verwendung von 1,1 KW Motoren beispielsweise mit drei Windungen zur Kompensation des Blindstromanteils das Auslangen gefunden werden kann.

Die erfindungsgemäße Vorrichtung ist mit Vorteil so weitergebildet, dass wenigstens ein weiterer Sensor an oder um einen Phasenleiter und den zu dieser Phase entgegengesetzt verlaufenden Rückleiter angeordnet ist, sodass auf diese Weise eine Zuordnung gemäß seinen Leistungsdaten zur Umstellrichtung erfolgen kann.

Wenn mehrere Weichendrehstromantriebe von einem einzigen Stellwerk aus betrieben werden, muss die Anzahl der Drosseln nicht erhöht werden. Es kann vielmehr die Ausbildung so getroffen sein, dass eine gemeinsame Drossel für eine Mehrzahl von Asynchronmotoren vorgesehen ist.

Die gesammelten Daten der Auswerteelektronik können in konventioneller Weise über Industriekommunikationsschnittstellen an einen Server des Betreibers übermittelt werden, wobei der Server die entsprechende Speicherung und Visualisierung der Messdaten vornehmen kann. Insbesondere können entsprechende Auswerteroutinen eingesetzt werden und Vergleiche mit Referenzkurven vorgenommen werden, um eine Früherkennung von Problemen und Schwergängigkeiten von Weichenstellantrieben zu ermöglichen. Die gemessenen Signale erlauben eine deutlich bessere Visualisierung und Erkennung von Abweichungen, als dies bei der Auswertung von Signalen ohne Blindstromkompensation möglich wäre.

Die Erfindung wird nachfolgend anhand der Zeichnung näher erläutert. In dieser zeigen Fig.1 eine schematische Darstellung des Messprinzips für einen Weichenantrieb, Fig.2 eine entsprechende Schaltungsanordnung für mehrere Weichenantriebe, welche hier von einem gemeinsamen Stellwerk gesteuert werden, und Fig.3 ein Diagramm der Messwerte nach erfolgter Blindstromkompensation.

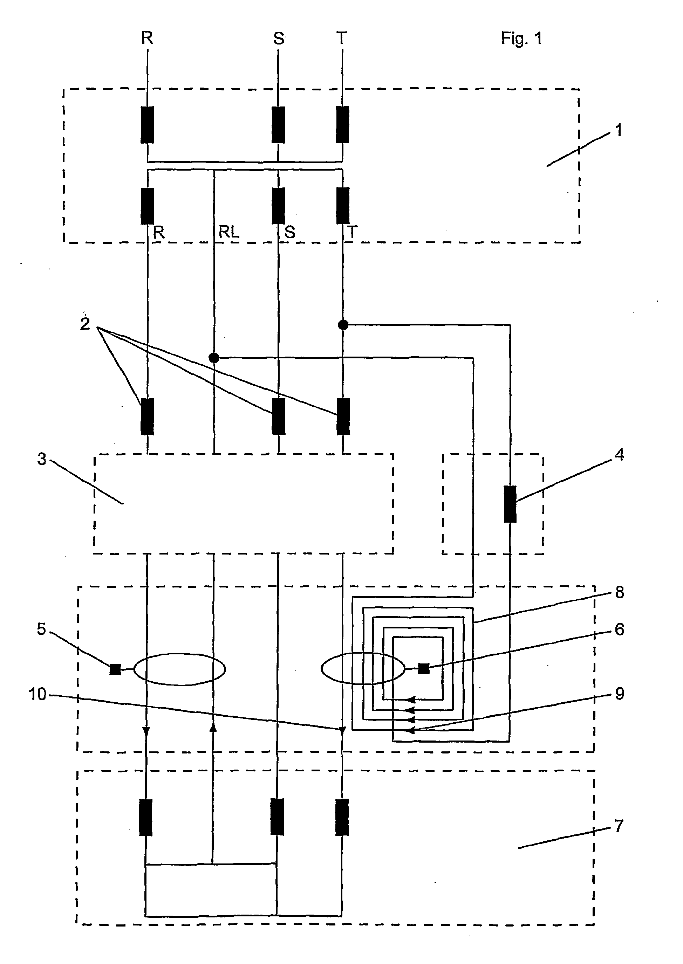

In Fig.1 ist die Stromversorgung schematisch mit 1 angedeutet und umfasst einen Weichentransformator, welcher die drei Drehstromphasen R, S und T sowie den Rückleiter als Vierdrahtanschluss zur Verfügung stellt. Die einzelnen Phasen R, S und T sind jeweils über Sicherungen 2 zur Weichenstellgruppe 3 geführt, wobei sich diese Weichenstellgruppe im Stellwerk befindet. Im Stellwerk ist weiters eine Drossel 4 an die T-Phase angelegt, wobei die erfindungsgemäße Vorrichtung im wesentlichen die beiden Sensoren 5 und 6 samt zugehöriger Auswerteelektronik enthält. Der Sensor 5 umgreift hierbei die R-Phase und damit einen Außenleiter sowie den Rückleiter, wobei aus dem hier gewonnenen Signal die Stellrichtung des Weichenantriebs abgeleitet werden kann. Der Weichenantrieb ist schematisch mit 7 angedeutet. Die Drossel 4 generiert einen Blindstromanteil, welcher über Leitungen 8 einfach oder in mehreren Windungen durch den Sensor 6 geführt ist und zum Rückleiter RL zurückgeführt ist. Der Strom durchfließt den Sensor 6 im Sinne der Pfeile 9 und damit entgegengesetzt dem Pfeil 10, welcher die Stromrichtung im Leiter der T-Phase zum Weichenantrieb 7 bezeichnet. Die gegenläufig geführten Blindstromanteile in dem Sensor 6 kompensieren den entsprechenden Blindstromanteil in der Leitung 10, sodass an dem Sensor 6 ein kompensiertes Signal abgegriffen wird, welches sich durch geringen oder optimal keinen Blindstromanteil auszeichnet. Die die Messspulen bzw. Sensoren 5 und 6 umfassende Einrichtung befindet sich ebenso wie die Weichenstellgruppe 3 und die Drossel 4 im Stellwerk, wobei die weiterführenden Leiter der R, S und T-Phasen zum Weichenantrieb 7 geführt sind.

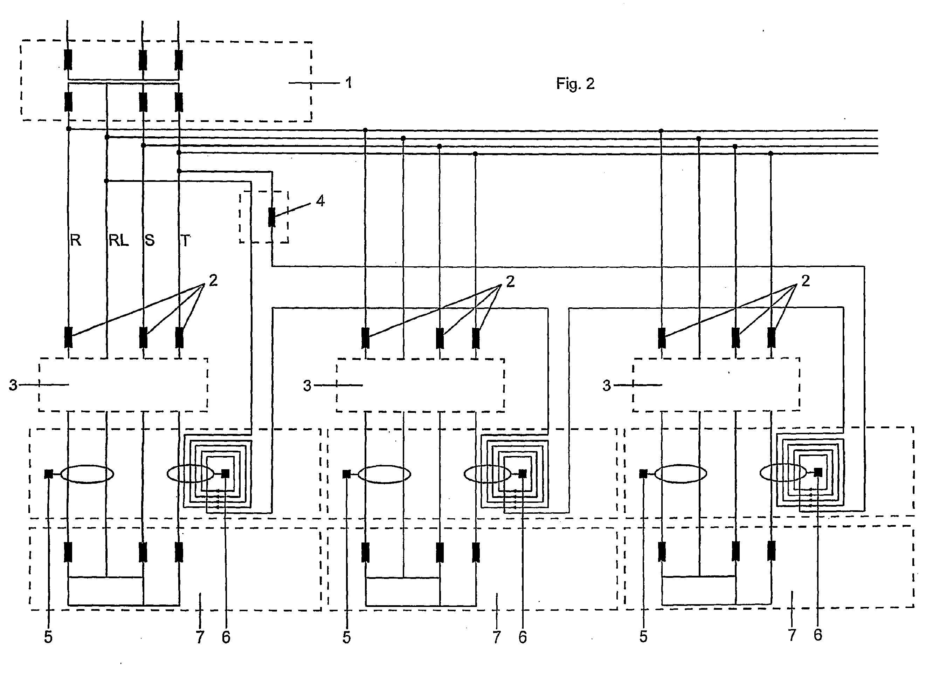

In der Darstellung nach Fig.2 wurden die Bezugszeichen der Fig.1 beibehalten, wobei für eine Mehrzahl von Weichenantrieben 7 eine einzige Drossel 4 in den T-Leiter eingeschaltet ist. Im übrigen entspricht die Darstellung der Darstellung nach Fig.1, wobei naturgemäß für jeden einzelnen Weichenantrieb 7 gesonderte Sensoren 5 und 6 vorgesehen sind, um die einzelnen Antriebe sicher zu überwachen.

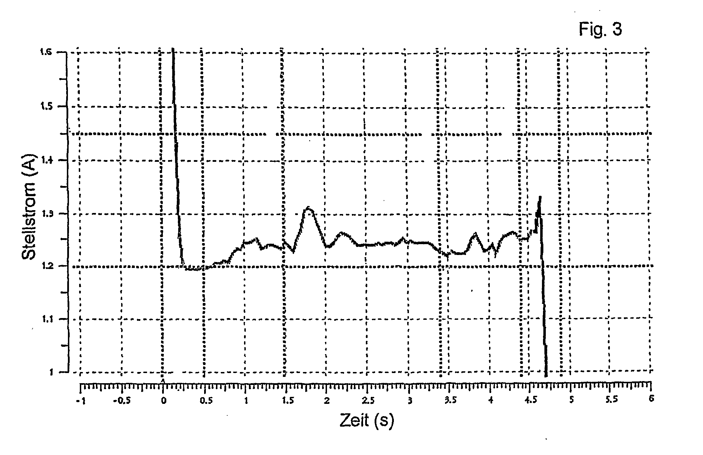

In Fig.3 schließlich ist das entsprechend kompensierte Messsignal dargestellt, wobei auf der y-Achse der kompensierte Stellstrom verringert um den Blindstromanteil aufgetragen ist und auf der x-Achse die Zeitkoordinate angedeutet ist. Der Stellstrom nimmt anfänglich rasch ab, was nicht zuletzt auf die rapide Abnahme des Blindstromanteils zurückzuführen ist, wobei die Kompensation naturgemäß erst nach diesem Anlaufstrom zum Tragen kommt. Nach etwa 1,5 sec ist in dem Diagramm nach Fig.3 die Entriegelungsphase ersichtlich, welcher nach etwa 3, 4 sec. die Umstellphase folgt. Nach etwa 4,4 sec. ist die Verrieglungsphase erreicht, worauf der Stellstrom entsprechend wieder abnimmt. Im gesamten Umstellbereich über die Entriegelungsphase, die Umstellphase und die Verriegelungsphase befindet sich der Stellstrom in einem Bereich zwischen einem Minimalwert, welcher im vorliegenden Fall mit 1,2 A angegeben ist, und einem Maximalwert von 1,45 A, wobei die Tatsache, dass der Stellstrom im kritischen Umstellbereich innerhalb dieser zulässigen Bandbreite verbleibt, als Indikator für die ordnungsgemäße Funktion des Weichenantriebs zu gelten hat.

## Patentansprüche

1. Vorrichtung zur kontaktlosen Ermittlung des Energiebedarfs eines Weichenstellantriebs (7) mit an eine Drehstromquelle über Leiter angeschlossenen Asynchronmotoren, **dadurch gekennzeichnet, dass** wenigstens eine Drossel (4), insbesondere Drosselspule, parallel zu einem Phasenleiter geschaltet ist und der an die Drossel (4) anschließende Leiter entgegengesetzt zu dem mit dem Motor verbundenen Phasenleiter an oder durch einen Sensor (5) geführt ist, wobei durch die in der Drossel (4) erzeugte Blindstromkomponente die in der über die Motorwicklung geführten Leitung zusätzlich zur Wirkstromkomponente enthaltene Blindstromkomponente zumindest teilweise kompensiert wird.

2. Vorrichtung nach Anspruch 1, **dadurch gekennzeichnet, dass** als über die Drossel (4) geführte Phase die T-Phase gewählt ist.

3. Vorrichtung nach Anspruch 1 oder 2, **dadurch gekennzeichnet, dass** wenigstens ein weiterer Sensor (6) an oder um einen Phasenleiter, insbesondere Außenleiterphase und den zu dieser Phase entgegengesetzt verlaufenden Rückleiter angeordnet ist, wobei der Phasenleiter und der Rückleiter unter Verwendung des weiteren Sensors (6) zur Ermittlung der Drehrichtung ausgewertet werden.

4. Vorrichtung nach Anspruch 1, 2 oder 3, **dadurch gekennzeichnet, dass** die Sensoren (5, 6) von den jeweiligen Phasen bzw. dem Rückleiter in axialer Richtung durchsetzt werden.

5. Vorrichtung nach einem der Ansprüche 1 bis 4, **dadurch gekennzeichnet, dass** als Sensoren (5, 6) Stromwandler bzw. Stromzangen eingesetzt sind.

6. Vorrichtung nach einem der Ansprüche 1 bis 5, **dadurch gekennzeichnet, dass** eine gemeinsame Drossel (4) für eine Mehrzahl von Asynchronmotoren vorgesehen ist.

7. Vorrichtung nach einem der Ansprüche 1 bis 6, **dadurch gekennzeichnet, dass** der an die Drossel (4) anschließende Leiter einfach oder in Form von Leiterwindungen mehrfach entgegengesetzt dem Phasenleiter an oder durch den Sensor (5) geführt ist.

## Claims

1. A device for the contactless determination of the energy demand of a switch actuating drive (7), including asynchronous motors connected to a three-phase current source via conductors, **characterized in that** at least one choke (4), in particular an inductance coil, is arranged in parallel with a phase conductor, and the conductor connected to the choke (4) is guided on or through a sensor (5) in a manner opposite to the phase conductor connected with the motor, wherein the idle current component contained in addition to the active power component in the line guided across the motor winding is at least partially compensated by the idle current component produced in the choke (4).

2. A device according to claim 1, **characterized in that** the T-phase is selected as the phase conducted across the choke (4).

3. A device according to claim 1 or 2, **characterized in that** at least one further sensor (6) is arranged on or about a phase conductor, in particular outer conductor phase, and the return conductor extending opposite to said phase, wherein the phase conductor and the return conductor are evaluated using said further sensor (6) in order to determine the direction of rotation.

4. A device according to claim 1, 2 or 3, **characterized in that** the respective phases and the return conductor, respectively, pass through the sensors (5, 6) in the axial direction.

5. A device according to any one of claims 1 to 4, **characterized in that** current transformers or current clamps are used as said sensors (5, 6).

6. A device according to any one of claims 1 to 5, **characterized in that** a common choke (4) is provided for a plurality of asynchronous motors.

7. A device according to any one of claims 1 to 6, **characterized in that** the conductor connected to the choke (4) is conducted on or through the sensor (5) in a manner opposite to the phase conductor, either singly or multiply in the form of conductor windings.

## Revendications

1. Dispositif pour la détermination sans contact du besoin en énergie d'un actionneur d'aiguillage (7) avec des moteurs asynchrones raccordés par des conducteurs à une source de courant triphasé, **caractérisé en ce qu'**au moins un self (4), en particulier une bobine de self, est monté parallèlement à un conducteur de phase et le conducteur raccordé au self (4) passe contre ou traverse un capteur (5) en opposition au conducteur de phase raccordé au moteur, la composante de courant réactif contenue dans la ligne passant par l'enroulement de moteur en plus de la composante de courant actif étant au moins partiellement compensée par la composante de courant réactif générée dans le self (4).

2. Dispositif selon la revendication 1, **caractérisé en ce que** la phase T est sélectionnée comme phase passant par le self (4).

3. Dispositif selon la revendication 1 ou la revendication 2, **caractérisé en ce qu'**au moins un autre capteur (6) est disposé sur ou autour d'un conducteur de phase, en particulier de conducteur extérieur et du conducteur de retour s'étendant en opposition à ladite phase, le conducteur de phase et le conducteur de retour étant analysés en recourant à l'autre capteur (6) pour déterminer le sens de rotation.

4. Dispositif selon la revendication 1, la revendication 2 ou la revendication 3, **caractérisé en ce que** les capteurs (5, 6) sont traversés en direction axiale par les phases respectives ou par le conducteur de retour.

5. Dispositif selon l'une des revendications 1 à 4, **caractérisé en ce que** des transformateurs de courant ou des pinces ampèremétriques sont mis en oeuvre en tant que capteurs (5, 6).

6. Dispositif selon l'une des revendications 1 à 5, **caractérisé en ce qu'**un self commun (4) est prévu pour une pluralité de moteurs asynchrones.

7. Dispositif selon l'une des revendications 1 à 6, **caractérisé en ce que** le conducteur raccordé au self (4) est passé contre ou traverse le capteur (5) une seule fois ou plusieurs fois sous la forme d'enroulements de conducteur en opposition au conducteur de phase.
